# FASCICULE DE BREVET EUROPEEN

(11) **EP 3 301 471 B1**
(45) Date de publication et mention de la délivrance du brevet: **06.03.2019**
(21) Numéro de dépôt: 17188663.3
(22) Date de dépôt: 31.08.2017
(51) Int. Cl.: G01S 7/02, G01S 7/282, H03C 1/00, H03K 3/00, G01S 7/03

(54) **PROCEDE DE MODULATION D'UNE ONDE HYPERFREQUENCE, SYSTEME D'EMISSION METTANT EN OEUVRE CE PROCEDE ET RADAR COMPORTANT UN TEL SYSTEME**
VERFAHREN ZUR MODULATION EINER HYPERFREQUENZWELLE, SENDESYSTEM, BEI DEM DIESES VERFAHREN ANGEWANDT WIRD, UND RADAR, DER EIN SOLCHES SYSTEM UMFASST
METHOD FOR MODULATING A MICROWAVE FREQUENCY WAVE, TRANSMISSION SYSTEM USING SAID METHOD AND RADAR COMPRISING SUCH A SYSTEM

(30) Priorité: 29.09.2016 FR 1601422
(43) Date de publication de la demande: 04.04.2018
(73) Titulaire: Thales, 92400 Courbevoie (FR)
(72) Inventeur: GARREC, Patrick, 33608 PESSAC (FR); HODE, Jean-Michel, 33608 PESSAC (FR); MONTIGNY, Richard, 33608 PESSAC (FR)
(74) Mandataire: Lucas, Laurent Jacques

(56) Documents cités:
- WO-A1-01/18559
- US-A1- 2005 046 609
- FAUST H H ET AL: "A spectrally clean transmitting system for solid state phased-array radars", RADAR CONFERENCE, 2004. PROCEEDINGS OF THE IEEE PHILADELPHIA, PA, USA APRIL 26-29, 2004, PISCATAWAY, NJ, USA,IEEE, 26 avril 2004 (2004-04-26), pages 140-144, XP010711546, DOI: 10.1109/NRC.2004.1316410 ISBN: 978-0-7803-8234-3

## Description

La présente invention concerne un procédé de modulation d'une onde hyperfréquence en impulsion. L'invention concerne également un système d'émission mettant en oeuvre ce procédé et un radar comportant un tel système. Elle s'applique notamment dans le domaine des antennes actives, plates ou conformées, équipant des systèmes radars ou de télécommunications.

Ces systèmes doivent de plus en plus respecter des normes de rayonnements non essentiels. En effet, avec le partage du spectre de rayonnement entre les différents domaines civils et militaires, il est devenu crucial de ne pas polluer les bandes de fréquences adjacentes.
La tenue de ces normes est un problème, notamment pour les systèmes d'émission à état solide comportant des émetteurs à base de transistors hyperfréquence ou de modules de transistors hyperfréquence. En effet, ces transistors sont commutés en courant ou en tension pour créer les impulsions d'émission hyperfréquence, et les fronts commutés génèrent des rayonnements parasites.
Une solution connue pour les radars à impulsions est de coucher les fronts temporels pour obtenir une impulsion à fronts mous sur le front montant et le front descendant afin de diminuer de façon notable l'encombrement spectrale d'émission. La théorie montre que les impulsions carrées provoquent des harmoniques en sinus cardinal. Avec les anciens radars à tube à ondes progressives, les fronts de montée et de descente de l'impulsion étaient modelés de façon pseudo gaussienne en utilisant par exemple des capacités variables dans le modulateur.
Lorsque l'on utilise des transistors hyperfréquence, la mise sous tension de ces éléments provoque souvent un surcroît d'oscillation d'amplitude qui est fortement préjudiciable et qui n'est pas maîtrisable.
Une des solutions connue est de moduler l'alimentation du transistor hyperfréquence pendant l'émission. Un inconvénient de cette solution est qu'elle met en jeu des courants forts pendant des temps très courts. Il faut donc des commandes d'alimentation très sophistiquées et un volume d'électronique important. Les transistors hyperfréquence de puissance travaillent souvent en classe C. La modulation de leur tension d'alimentation,
si elle est possible, n'est pas garantie par le constructeur. De plus, du fait des capacités de découplage des transistors, la modulation des alimentations sur le front descendant est difficilement maîtrisable.

Une autre solution divulguée dans la demande US 2005/046609 est de réduire les interférences par application de perturbations de phase aux bords des impulsions produites par la source, pour ainsi avoir tendance à annuler l'énergie de la bande latérale située dans la largeur de bande nominale des équipements occupant les largeurs de bande nominale adjacentes. Les autres solutions connues utilisent la zone linéaire de l'amplification pour moduler l'impulsion en amplitude. Cette modulation se fait par modulation du niveau du signal d'attaque des transistors hyperfréquence dans la limite du fonctionnement linéaire de ceux-ci.
Ces solutions sont limitées à la zone linéaire des transistors et ne permettent pas d'optimiser les formes d'onde. Elles imposent une linéarité sur toute la chaîne depuis la génération de forme d'onde jusqu'à l'amplification. De plus le rendement est plus faible dans ce cas et souvent ces modulations entraînent une dissipation thermique qui se fait dans les composants ou des charges.
Un but de l'invention est de pallier ces inconvénients et notamment de s'affranchir des contraintes liées au besoin de linéarité.
A cet effet, l'invention a pour objet un procédé de modulation d'une onde hyperfréquence en impulsions dans lequel, l'onde étant émise au moyen d'une antenne constituée d'un réseau d'éléments rayonnants, on émet deux ondes en impulsions modulées chacune par une loi de déphasage dite déphasage de modulation, les déphasages étant en opposition, une première onde étant émise par un sous-réseau d'éléments rayonnants dits impairs et la deuxième onde étant émise par un deuxième sous-réseau d'éléments rayonnants dits pairs, les deux sous-réseaux étant entrelacés, l'onde émise étant la combinaison de ladite première onde et de la dite deuxième onde. Dans un mode de mise en oeuvre possible, lesdites deux ondes sont obtenues à partir d'un même signal en impulsion s(t), ledit signal étant modulé par un premier déphasage de modulation pour les éléments rayonnant impairs et par un second déphasage de modulation pour les éléments pairs.

Pour chaque élément rayonnant, un déphasage de pointage ϕ_{P}, propre à chaque élément rayonnant, est sommé au déphasage de modulation.

Dans un mode de mise en oeuvre possible :
- ledit premier déphasage de modulation est appliqué sur le front montant de l'impulsion en variant de -π/2 à 0 et sur le front descendant en variant de 0 à -π/2 ;
- ledit second déphasage de modulation est appliqué sur le front montant de l'impulsion en variant de π/2 à 0 et sur le front descendant en variant de 0 à π/2.

Un module d'émission et de réception étant couplé à chaque élément rayonnant, ledit module comportant un déphaseur appliquant ledit déphasage de pointage, ledit déphaseur applique par exemple en outre le déphasage de modulation.

Une pondération de Hamming est par exemple appliquée sur lesdites ondes en impulsion.

Dans un autre mode de mise en oeuvre possible, une pondération de Hann gaussienne est appliquée sur lesdites ondes en impulsion.

L'invention a également pour objet un système d'émission mettant en oeuvre le procédé tel que précédemment décrit.
Dans un mode de réalisation possible, un module d'émission et de réception étant couplé à chaque élément rayonnant, ledit module comportant un déphaseur appliquant au signal d'entrée (st)) un déphasage commandé par un circuit de commande, lesdites lois de déphasage de modulation sont mémorisées sous forme d'échantillons dans une mémoire, lesdits échantillons de déphasage étant fournis audit circuit de commande à la cadence d'une horloge.

Ledit signal d'entrée s(t) est par exemple fourni par un générateur de forme d'onde commun à tous les éléments rayonnants.

Pour chaque élément rayonnant, un additionneur somme par exemple les échantillons de déphasage délivrés par ladite mémoire avec le déphasage de pointage ϕ_{P}, le déphasage résultant étant fourni audit circuit de commande.

L'invention a également pour objet un radar comportant un tel système.

D'autres caractéristiques et avantages de l'invention apparaîtront à l'aide de la description qui suit, faite en regard de dessins annexés qui représentent :
- La figure 1, le principe de réalisation d'un modulateur d'amplitude selon l'art antérieur ;
- La figure 2, le principe de modulation d'amplitude selon l'invention ;
- La figure 3, un exemple de réalisation d'un système d'émission selon l'invention.

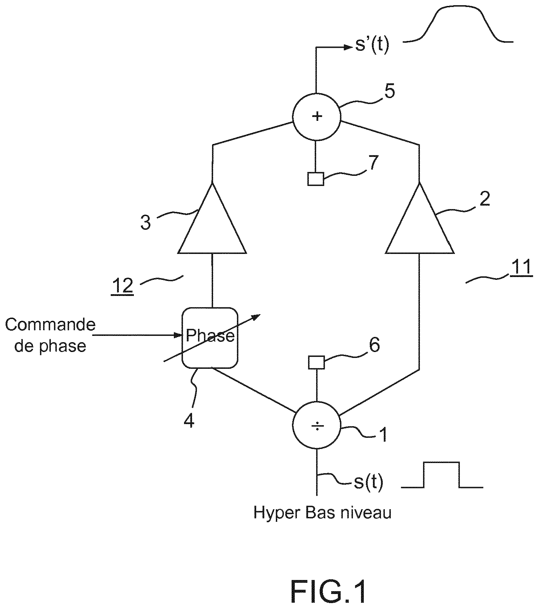

La figure 1 présente le principe de réalisation d'un modulateur d'amplitude selon l'art antérieur. Un signal s(t) impulsionnel bas niveau, à fronts raides, entre dans un diviseur 1, lequel se divise en deux branches 11, 12. La première branche 11 comporte un amplificateur de puissance 2 amplifiant la partie du signal s(t) transitant par cette branche. La deuxième branche 12 comporte également un amplificateur de puissance 3 mais aussi un déphaseur 4 commandable par un signal de commande de phase. La partie du signal s(t) transitant par cette branche est donc amplifiée et déphasée, le déphasage appliqué étant commandable. Les amplificateurs de puissance 2, 3 sont des modules d'amplification et plus généralement des modules d'émission/réception, encore appelés TR modules. On considère ici leur fonction d'amplification.
Les deux branches 11, 12 sont reliées à un sommateur 5 de sorte que les parties de signaux issues de ces branches se combinent à l'intérieur de ce sommateur. Le signal de puissance s'(t) reconstitué en sortie du sommateur est modelé dans ce sens qu'il présente des fronts amortis grâce au déphasage 4. Le déphase appliqué est par exemple égal à π/2. Le signal ainsi amplifié et modelé est rayonné via une antenne à éléments rayonnants. La sommation est effectuée par un dispositif en anneau, formé des deux branches 11, 12. Les pertes liées au modelage de l'impulsion sont dissipées dans les composants et dans les charges 6, 7. Elles participent à l'échauffement et nécessitent un refroidissement important.

Elle présente un rendement faible et entraîne une forte dissipation thermique dans la charge du sommateur et donc à l'intérieur de l'équipement.

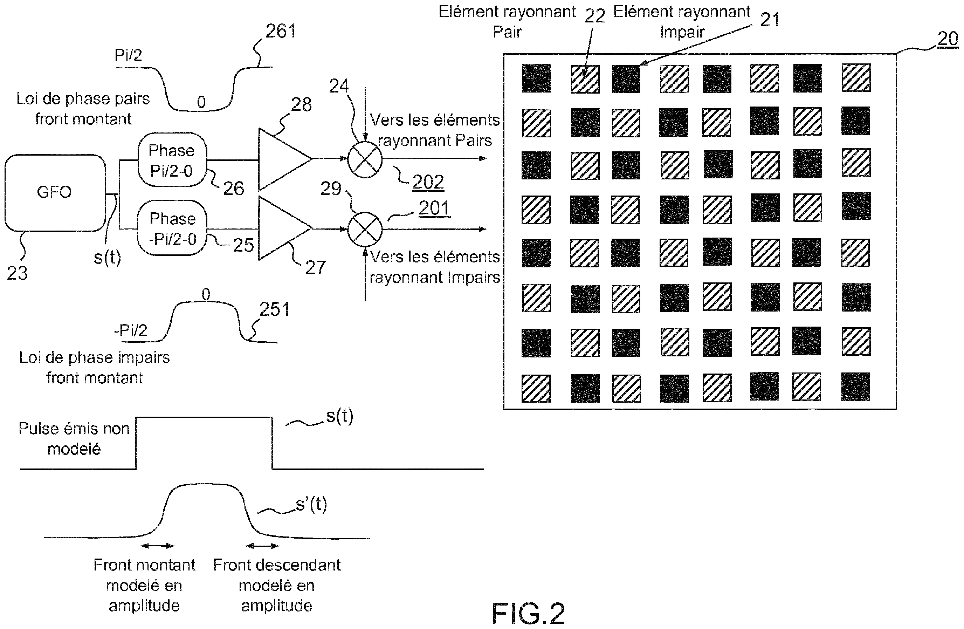

La figure 2 illustre le principe de modulation d'une onde impulsionnelle selon l'invention, cette modulation ayant pour résultat de coucher les fronts montant et descendant de l'impulsion émise. L'antenne 20 composée d'éléments rayonnants comporte deux sous-réseaux :
- Un premier sous-réseau d'éléments dit impairs 21 disposés en lignes et en colonnes ;
- Un deuxième sous-réseau d'éléments dit pairs 22 disposés en lignes et en colonnes.
Les deux sous-réseaux sont entrelacés, ou entrecroisés, de sorte qu'un élément impair ne voisine qu'avec des éléments pairs, et qu'un élément pair ne voisine qu'avec des éléments impairs.
Le premier sous-réseau, des éléments impairs, est alimenté par des signaux issus d'une première chaîne d'amplification 201. Le deuxième sous-réseau, des éléments pairs, est alimenté par des signaux issus d'une deuxième chaîne d'amplification 202.
Le signal impulsionnel s(t) est par exemple issu d'un générateur de forme d'onde 23 et se divise dans les deux chaînes d'amplification. Chaque chaîne applique un déphasage 25, 26 selon une loi de phase donnée 251, 261, les deux lois de phases étant symétriques. La phase varie de -π/2 à 0 pour l'un, et de π/2 à 0 pour l'autre.
Dans chaque chaîne, le signal est par ailleurs amplifié par un amplificateur ou module d'amplification 27,28. Chaque chaîne est terminée par un mélangeur, la sortie de chaque amplificateur étant connectée à une entrée d'un mélangeur hyperfréquence 29, 24, l'autre entrée du mélangeur recevant l'onde porteuse du signal hyperfréquence d'émission.
Le signal déphasé et amplifié en sortie de la première chaîne alimente donc le premier sous-réseau, des éléments impairs. Le signal déphasé et amplifié en sortie de la seconde chaîne alimente le deuxième sous-réseau, des éléments pairs. L'impulsion finale s(t) est alors générée au niveau de l'antenne et la modulation est faite dans l'air par recombinaison des signaux pairs et impairs. On obtient un signal de sortie s'(t) modelé en amplitude au niveau du front montant et du front descendant. En d'autres termes, la combinaison dans l'air des ondes déphasées en opposition de phase produit la modulation d'amplitude souhaitée. Avantageusement, les pertes de modulation sont ainsi en extérieur du système d'émission. Il n'est donc pas nécessaire de prévoir un refroidissement de l'échauffement dû aux pertes liées à la modulation. Les variations de puissance des différentes chaines, grâce à une distribution statistique ne sont pas à prendre en compte.
Les formes d'onde, opposées, ainsi générées en sorties des chaînes 201, 202 sont guidées de façon connue vers les éléments rayonnants par un circuit de routage spécifique non représenté.
En plus de ces déphasages 251, 261, des lois temporelles de déphasage sont appliquées à chaque élément rayonnant, de façon connue, pour produire un faisceau d'antenne balayant l'espace.

Un avantage de l'invention est qu'elle est simple à mettre en oeuvre. Il suffit de deux déphaseurs 27, 28 appliquant des déphasages symétriques, pour modeler le signal.
Le schéma de la figure 2 illustre le principe de l'invention. Il est uniquement fonctionnel. Il est possible notamment de réaliser les déphasages 251, 261 dans le générateur de forme d'onde 23, les déphaseurs 25, 26 étant alors supprimés.

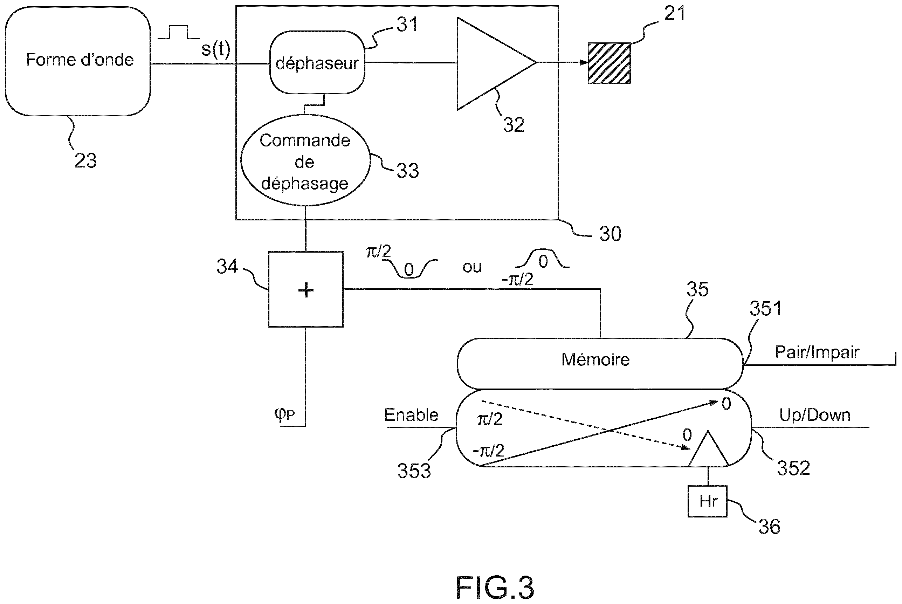

La figure 3 présente un exemple de réalisation d'un dispositif mettant en oeuvre l'invention appliqué à une antenne active. Pour plus de clarté, on présente un seul élément rayonnant 21 de l'antenne active.
Pour réaliser les déphasages 251, 261, une solution économique consiste à utiliser le déphaseur 31 intégré dans les modules d'émission et de réception 30, ou modules de pointage, des antennes actives, chaque module alimentant un élément rayonnant. En effet, chaque module contient un déphaseur 31 utilisé pour le pointage du faisceau d'antenne. Comme rappelé ci-dessus, il est connu de former et d'orienter le faisceau application d'une loi de phase propre à chaque élément rayonnant.
La figure 3 montre donc un module de pointage 30 fournissant un signal hyperfréquence impulsionnel amplifié et déphasé à l'élément rayonnant 21 qui lui est associé. Le schéma de la figure 3 est un schéma de principe et ne détaille pas le mode de transmission du signal hyperfréquence vers l'élément rayonnant. Ce signal est acheminé vers l'élément rayonnant par un circuit de routage de façon connue. La figure 3 présente un seul élément rayonnant 21 et son module associé, le dispositif complet comportant tous les éléments des deux sous-réseaux, impair et pair, et leurs modules associés, c'est-à-dire l'antenne active. Comme on le verra par la suite, avantageusement, l'invention peut être mise en oeuvre par des antennes actives existantes moyennant peu de modifications.

On revient au schéma de la figure 3. En plus du déphaseur 31, le module comporte un amplificateur 32. Le signal d'entrée du module, bas niveau, est fourni par un générateur de forme d'onde 23 qui peut être commun à tous les modules. Le déphaseur 31 réalise le déphase destiné au pointage du faisceau en fonction d'une loi de phase donnée. De façon connue, cette loi de phase applique un déphasage sur chaque élément rayonnant. A cet effet, le module 30 comporte un circuit 33 de commande de déphasage, qui reçoit la valeur du déphasage ϕₚ à appliquer. Celle-ci est fournie sous forme codée par les moyens de traitement, plus particulièrement elle est issue d'une table de pointage comportant la ou les lois de pointage, et donc de déphasage, à appliquer à tous les éléments rayonnants.
Parallèlement, le déphaseur applique le déphasage 251, 261 destiné à modeler le signal impulsionnel transmis à l'élément rayonnant.
Il faut ainsi parcourir pendant le front montant les valeurs de -π/2 à 0 pour les éléments pairs et de +π/2 à 0 pour les éléments impairs, en ajoutant le déphasage de dépointage ϕₚ correspondant à l'angle visé. A cet effet, le déphasage -π/2 à 0 ou +π/2 à 0, selon que le module 30 est associé à un élément pair ou impair, est ajouté à la valeur ϕₚ par un additionneur 34. Ces valeurs de déphasage sont numérisées et échantillonnées. En sortie de l'additionneur 34, la valeur de déphasage appliquée est fournie au circuit 33 de commande de déphasage. La consigne de déphasage est transmise au déphaseur 31 qui l'applique au signal s(t) entrant dans le module.
Une mémoire 35 comporte les valeurs échantillonnées des fronts montants -π/2 à 0 et +π/2 à 0. Une information binaire, paire ou impaire, présente à une entrée 351 de la mémoire indique s'il faut appliquer le déphasage -π/2 à 0 ou le déphasage +π/2 à 0. Selon l'information, la mémoire délivre l'un ou l'autre déphasage. On peut ainsi utiliser une même mémoire pour tous les modules, qu'ils soient affectés à un élément pair ou à un élément impair. Plus précisément, une mémoire est par exemple affectée à chaque élément rayonnant, mais selon l'élément rayonnant est pair ou impair, l'entrée 351 est dans un état ou un autre, toutes les mémoires ayant le même contenu. On peut aussi prévoir une mémoire affectée à l'ensemble des éléments impairs et une autre affectée à l'ensemble des éléments pairs.
Une information binaire, dite Up/Down, présente à une entrée 352 est synchronisée avec le signal impulsionnel s(t) à modeler. Au front montant du signal s(t), l'information Up/Down passe dans un état donnant l'instruction de parcourir, à une fréquence d'horloge 36, les valeurs de -π/2 à 0 ou +π/2 à 0 selon l'information pair/impair. Au front descendant du signal s(t), l'information Up/Down commute dans l'autre état donnant instruction de parcourir les valeurs dans l'autre sens. On applique ainsi sur les fronts montant et descendant du signal s(t) les lois de modulation en phase 251, 261 tels que décrits précédemment.
Une information binaire, dite « Enable », est présente sur une entrée 351. Dans un état donné correspondant à la phase d'émission des éléments rayonnant, cette information active le balayage des valeurs de déphasage, celles-ci étant fournies à l'additionneur 34. Dans l'autre état, correspondant à une phase de non émission, notamment en réception, la mémoire est inactive et aucun déphasage n'est fourni à l'additionneur.
La mémoire est par exemple téléchargeable pour adapter les lois de modulations en phase en fonction des besoins. En particulier il est possible d'adapter le nombre d'échantillons de phases entre -π/2 à 0 ou +π/2 à 0. Ces valeurs échantillonnées, constituant les différentes corrections de phases échantillonnées entre -π/2 à 0 et +π/2 à 0, sont stockées dans des tables.
On peut utiliser ces différentes tables pour faire de la modulation d'amplitude pour des classes d'amplification qui ne le permettent pas. Ceci peut notamment être utile pour des liaisons de communication, ou pour adapter la puissance d'un système de détection en fonction de la distance.
L'horloge 36 parcourt la table des corrections de phase (entre -π2 et 0 ou entre π/2 et 0) pour ajouter ces valeurs de déphasage à la consigne de pointage demandée. La cadence de cette horloge est dimensionnée en fonction du nombre de points nécessaires pour échantillonner le front. Une valeur indicative pourrait être une dizaine. La loi de phase est programmée en fonction de la granularité des déphaseurs et du besoin de pureté spectral exigée. Il en est de même pour le front descendant, bien que la chute des alimentations soit moins brutale et inflige une pente au front descendant. Cette pente est toutefois difficilement contrôlable. On peut par exemple prévoir une chronométrie pour déclencher l'horloge au début du front de l'impulsion et un signal pour le faire décroitre lorsque l'on veut commencer à modeler l'impulsion de descente.
Plus précisément, un circuit électronique à base de compteurs peut permettre de formater les flancs des impulsions et d'éviter ainsi des harmoniques non désirées. Ces compteurs commandent en fait la fréquence d'horloge et la cadence de balayage des tables de correction de phase (valeurs de déphasage échantillonnées). La plus ou moins grande rapidité de la cadence commande la pente.
Il est possible également de prévoir des pondérations sur les échantillons de phase. Il est connu dans la littérature que les pondérations les plus efficaces pour diminuer les harmoniques non désirées sont celles de Hamming. Toutefois d'autres pondérations telles que les pondérations de Hann gaussienne par exemple peuvent être utilisées en fonction du besoin. Dans ce dernier cas, il est préférable d'intégrer la loi de modulation en phase dans la table de pointage pour éviter d'avoir à gérer deux circuits de déphasage. Comme décrit précédemment un compteur rapide (ou une horloge) permet par exemple de balayer la mémoire 35 avec une indexation permettant de faire varier la phase de -π/2 à 0 et de π/2 à 0 respectivement pour l'emplacement pair et pour l'emplacement impair. L'horloge doit être rapide pour générer la pondération de Hamming désirée, la rapidité étant fonction du nombre de points de déphasage à générer. L'ordre de grandeur étant d'échantillonner au moins 10 fois les fronts de l'impulsion pour les coucher de 10% de la largeur de l'impulsion s(t).

Avantageusement, l'invention permet de s'affranchir des contraintes liées au besoin de linéarité. Elle permet de gérer la forme de l'impulsion émise quelques soient les classes d'amplification choisies, la seule contrainte étant que les amplificateur 32 des modules d'émission et de réception soient de même nature, ce qui est le cas usuel puisque ces modules sont standardisés. Enfin, l'invention permet d'évaluer les pertes liées à la modulation en extérieur du radar, directement en sortie d'antenne.

## Revendications

1. Procédé de modulation d'une onde hyperfréquence en impulsions **caractérisé en ce que**, l'onde étant émise au moyen d'une antenne (20) constituée d'un réseau d'éléments rayonnants (21, 22), on émet deux ondes en impulsions modulées chacune par une loi de déphasage (251, 261) dite déphasage de modulation, les déphasages étant en opposition, une première onde étant émise par un sous-réseau d'éléments rayonnants dits impairs (21) et la deuxième onde étant émise par un deuxième sous-réseau d'éléments rayonnants dits pairs (22), les deux sous-réseaux étant entrelacés, l'onde émise étant la combinaison de ladite première onde et de la dite deuxième onde, lesdites deux ondes étant obtenues à partir d'un même signal en impulsion (s(t)), ledit signal étant modulé par un premier déphasage de modulation (251) pour les éléments rayonnants impairs et par un second déphasage de modulation (261) pour les éléments pairs,
- ledit premier déphasage de modulation (251) est appliqué sur le front montant de l'impulsion en variant de -π/2 à 0 et sur le front descendant en variant de 0 à -π/2 ;
- ledit second déphasage de modulation (261) est appliqué sur le front montant de l'impulsion en variant de π/2 à 0 et sur le front descendant en variant de 0 à π/2.

2. Procédé selon la revendication 1, **caractérisé en ce que** pour chaque élément rayonnant, un déphasage de pointage (ϕ_{P}), propre à chaque élément rayonnant (21, 22), est sommé au déphasage de modulation (251, 261).

3. Procédé selon l'une quelconque des revendications précédentes, **caractérisé en ce qu'**un module (30) d'émission et de réception étant couplé à chaque élément rayonnant (21, 22), ledit module comportant un déphaseur (31) appliquant ledit déphasage de pointage, ledit déphaseur applique en outre le déphasage de modulation.

4. Procédé selon l'une quelconque des revendications précédentes, **caractérisé en ce qu'**une pondération de Hamming est appliquée sur lesdites ondes en impulsion.

5. Procédé selon l'une quelconque des revendications 1 à 3, **caractérisé en ce qu'**une pondération de Hann gaussienne est appliquée sur lesdites ondes en impulsion.

6. Système d'émission comportant une antenne composée d'un réseau d'éléments rayonnants (21, 22), un module (30) d'émission et de réception couplé à chaque élément rayonnant, ledit module comportant un déphaseur (31) appliquant au signal d'entrée (st)) un déphasage commandé par un circuit de commande (33), lesdites loi de déphasage de modulation (251, 261) sont mémorisées sous forme d'échantillons dans une mémoire (35), lesdits échantillons de déphasage étant fournis audit circuit de commande (33) à la cadence d'une horloge (36), **caractérisé en ce que** le système d'émission met en oeuvre le procédé selon l'une quelconque des revendications 1-5.

7. Système d'émission selon la revendication 6, **caractérisé en ce que** ledit signal d'entrée (s(t)) est fourni par un générateur de forme d'onde (31) commun à tous les éléments rayonnants (21, 22).

8. Système d'émission selon l'une quelconque des revendications 6 ou 7, **caractérisé en ce que** pour chaque élément rayonnant, un additionneur (34) somme les échantillons de déphasage délivrés par ladite mémoire (35) avec le déphasage de pointage (ϕ_{P}), le déphasage résultant étant fourni audit circuit de commande (33).

9. Radar, **caractérisé en ce qu'**il comporte un système d'émission selon l'une quelconque des revendications 6 à 8.

## Patentansprüche

1. Verfahren zur Modulation einer Hyperfrequenz-Impulswelle, **dadurch gekennzeichnet dass**, da die Welle mit Hilfe einer Antenne (20) gesendet wird, welche aus einem Netzwerk von Abstrahlelementen (21, 22) gebildet ist, zwei Impulswellen werden ausgesendet, welche jeweils durch ein Phasenverschiebungsgesetz (251, 261), genannt Modulations-Phasenverschiebung, moduliert werden, wobei die Phasenverschiebungen entgegengesetzt sind, wobei eine erste Welle durch ein Unternetzwerk von sogenannten ungeraden Abstrahlelementen (21) und die zweite Welle durch ein zweites Unternetzwerk von sogenannten geraden Abstrahlelementen (22) gesendet wird, wobei beide Unternetzwerke miteinander verflochten sind, wobei die ausgesendete Welle die Kombination aus der ersten Welle und der zweiten Welle ist, wobei beide Wellen anhand eines gleichen Impulssignals (s(t)) erzielt werden, wobei das Signal durch eine erste Modulations-Phasenverschiebung (251) für die ungeraden Abstrahlelemente und durch eine zweite Modulations-Phasenverschiebung (261) für die geraden Elemente moduliert wird,
- wobei die erste Modulations-Phasenverschiebung (251) auf der ansteigenden Front des Impulses mit einer Variation von -π/2 bis 0 und auf der absteigenden Front mit einer Variation von 0 bis -π/2 angewandt wird;
- wobei die zweite Modulations-Phasenverschiebung (261) auf der ansteigenden Front des Impulses mit einer Variation von π/2 bis 0 und auf der absteigenden Front mit einer Variation von 0 bis π/2 angewandt wird.

2. Verfahren nach Anspruch 1, **dadurch gekennzeichnet, dass** für jedes Abstrahlelement eine Richt-Phasenverschiebung (ϕ_{P}), welche für jedes Abstrahlelement (21, 22) spezifisch ist, in der Modulations-Phasenverschiebung (251, 261) summiert wird.

3. Verfahren nach einem der vorhergehenden Ansprüche, **dadurch gekennzeichnet, dass** ein Sende- und Empfangsmodul (30) mit jedem Abstrahlelement (21, 22) gekoppelt ist, wobei das Modul einen Phasenschieber (31) beinhaltet, welcher die Richt-Phasenverschiebung anwendet, wobei der Phasenschieber zudem die Modulations-Phasenverschiebung anwendet.

4. Verfahren nach einem der vorhergehenden Ansprüche, **dadurch gekennzeichnet, dass** eine Hamming-Gewichtung auf die Impulswellen angewandt wird.

5. Verfahren nach einem der Ansprüche 1 bis 3, **dadurch gekennzeichnet, dass** eine Gaußsche Hann-Gewichtung auf die Impulswellen angewandt wird.

6. Sendesystem, beinhaltend eine Antenne, welche aus einem Netzwerk von Abstrahlelementen (21, 22) besteht, ein Sende- und Empfangsmodul (30), welches mit jedem Abstrahlelement gekoppelt ist, wobei das Modul einen Phasenschieber (31) beinhaltet, welcher auf das Eingangssignal (s(t)) eine durch einen Steuerkreis (33) gesteuerte Phasenverschiebung anwendet, wobei die Modulations-Phasenverschiebungsgesetze (251, 261) in Form von Abtastwerten in einem Speicher (35) gespeichert sind, wobei die Phasenverschiebungs-Abtastwerte dem Steuerkreis (33) im Takt einer Uhr (36) bereitgestellt werden,
**dadurch gekennzeichnet, dass** das Sendesystem das Verfahren nach einem der Ansprüche 1 bis 5 umsetzt.

7. Sendesystem nach Anspruch 6, **dadurch gekennzeichnet, dass** das Eingangssignal (s(t)) durch einen Wellenformerzeuger (31) bereitgestellt wird, welcher allen Abstrahlelementen (21, 22) gemeinsam ist.

8. Sendesystem nach einem der Ansprüche 6 oder 7, **dadurch gekennzeichnet, dass** für jedes Abstrahlelement ein Summierer (34) die Phasenverschiebungs-Abtastwerte, welche durch den Speicher (35) abgegeben werden, mit der Richt-Phasenverschiebung (ϕ_{P}) summiert, wobei die resultierende Phasenverschiebung dem Steuerkreis (33) bereitgestellt wird.

9. Radar, **dadurch gekennzeichnet, dass** er ein Sendesystem nach einem der Ansprüche 6 bis 8 beinhaltet.

## Claims

1. Method for modulating a microwave frequency pulse wave, **characterized in that**, the wave being transmitted by means of an antenna (20) made up of an array of radiating elements (21, 22), two pulse waves are transmitted, each modulated by a phase shift law (251, 261) known as modulation phase shift, the phase shifts being in opposition, a first wave being transmitted by a sub-array of radiating elements referred to as odd (21) and the second wave being transmitted by a second sub-array of radiating elements referred to as even (22), the two sub-arrays being interleaved, the transmitted wave being the combination of said first wave and said second wave, said two waves being obtained from the same pulse signal (s(t)), said signal being modulated by a first modulation phase shift (251) for the odd radiating elements and by a second modulation phase shift (261) for the even elements,
- said first modulation phase shift (251) is applied to the rising edge of the pulse by varying from -π/2 to 0 and to the falling edge by varying from 0 to -π/2;
- said second modulation phase shift (261) is applied to the rising edge of the pulse by varying from π/2 to 0 and to the falling edge by varying from 0 to π/2.

2. Method according to claim 1, **characterized in that**, for each radiating element, a pointing phase shift (ϕ_{P}), specific to each radiating element (21, 22), is added to the modulation phase shift (251, 261).

3. Method according to any one of the preceding claims, **characterized in that**, a transmission and reception module (30) being connected to each radiating element (21, 22), said module comprising a phase shifter (31) applying said pointing phase shift, said phase shifter furthermore applies the modulation phase shift.

4. Method according to any one of the preceding claims, **characterized in that** a Hamming weighting is applied to said pulse waves.

5. Method according to any one of claims 1 to 3, **characterized in that** a Gaussian Hann weighting is applied to said pulse waves.

6. Transmission system comprising an antenna made up of an array of radiating elements (21, 22),
a transmission and reception module (30) connected to each radiating element, said module comprising a phase shifter (31) applying a phase shift controlled by a control circuit (33) to the input signal (st)), said modulation phase shift laws (251, 261) are stored in the form of samples in a memory (35), said phase shift samples being supplied to said control circuit (33) at the frequency of a clock (36),
**characterized in that** the transmission system implements the method according to any one of claims 1 to 5.

7. Transmission system according to claim 6, **characterized in that** said input signal (s(t)) is supplied by a waveform generator (31) common to all of the radiating elements (21,22).

8. Transmission system according to any one of claims 6 or 7, **characterized in that**, for each radiating element, an adder (34) summates the phase shift samples delivered by said memory (35) with the pointing phase shift (ϕ_{P}), the resulting phase shift being supplied to said control circuit (33).

9. Radar, **characterized in that** it comprises a transmission system according to any one of claims 6 to 8.
